Europäisches Patentamt

European Patent Office

Office européen des brevets

(11) Publication number : **0 612 085 A2**

(19)

## (12) EUROPEAN PATENT APPLICATION

(21) Application number : 94301074.4

(22) Date of filing : 15.02.94

(51) Int. Cl.⁵ : **H01H 1/02, C23C 30/00, C23C 14/16, C23C 16/06, C23C 14/06, C23C 16/30, C23C 14/02, C23C 16/02, C23C 14/58, C23C 16/56**

(30) Priority : 15.02.93 JP 25553/93
05.10.93 JP 271155/93

(43) Date of publication of application :
24.08.94 Bulletin 94/34

(84) Designated Contracting States :
**DE GB NL**

(71) Applicant : **THE FURUKAWA ELECTRIC CO., LTD.**
6-1, 2-chome, Marunouchi
Chiyoda-ku
Tokyo (JP)

(72) Inventor : **Ozaki, Masanori, c/o The Furukawa Electric Co., Ltd.,**
6-1 Marunouchi 2-chome
Chiyoda-ku, Tokyo (JP)
Inventor : **Murata, Hideaki, c/o The Furukawa Electric Co., Ltd.,**
6-1 Marunouchi 2-chome
Chiyoda-ku, Tokyo (JP)
Inventor : **Ohashi, Yoshikazu, c/o The Furukawa Electric Co., Ltd.,**
6-1 Marunouchi 2-chome
Chiyoda-ku, Tokyo (JP)

(74) Representative : **Woodman, Derek**
Frank B. Dehn & Co.
European Patent Attorneys
Imperial House
15-19 Kingsway
London WC2B 6UZ (GB)

(54) Encapsulated contact material and process for producing the same.

(57) An encapsulated contact material comprising a substrate and a contact-coating layer formed on said substrate, characterized in that said contact-coating layer comprises at least one metal selected from a group consisting of Mo, Zr, Nb, Hf, Ta and W or an alloy made of two or more of these metals and containing from 0.5 to 10 atomic % of at least one element selected from a group consisting of Li, K, Ce, Cs, Ba, Sr, Ca, Na, Y, La, Sc, Th and Rb and has a thickness of 0.1 $\mu$m or more ; or comprises at least one metal selected from a group consisting of Mo, Zr, Nb, Hf, Ta and W or an alloy made of two or more of these metals and containing from 0.1 to 5 % by weight of at least one oxide comprising at least one metal selected from a group consisting of Li, K, Ce, Cs, Ba, Sr, Ca, Na, Y, La, Sc, Th and Rb and has a thickness of 0.1 $\mu$m or more. This encapsulated contact material has a low contact resistance and an excellent arc resistance.

EP 0 612 085 A2

This invention relates to an encapsulated contact material to be used in an encapsulated contact of, for example, a lead switch and a process for producing the same. More particularly, it relates to an encapsulated contact material, which shows a low contact resistance and remains stable in a make-and-break action and has a long operating life, and a process for producing the same at a low cost.

An encapsulated contact has a structure comprising a container made of, for example, glass, metals or ceramics and a contact material being hermetically encapsulated therein.

As encapsulated contact materials, there have been used substrates made of alloys such as Fe/Ni and having a surface coated with, for example, Rh or Ru. This is because Rh and Ru have large electric conductivity, high hardness, high melting point and excellent resistance to abrasion.

This encapsulated contact material is produced by plating the surface of a substrate with a metal such as Ag, Au or Cu and then further plating the surface of the plated metal with Rh or Ru. The plating of the surface of the substrate with a metal such as Ag, Au or Cu is performed in order to prevent the diffusion of Rh or Ru into the substrate in a make-and-break action on the contact and to elevate the adhesiveness of Rh or Ru constituting the surface of the contact portion (contact-coating layer) with the substrate.

However, the above-mentioned encapsulated contact materials involve expensive Rh or Ru and thus cost a great deal.

Under these circumstances, there has been proposed and expected much in recent years to use a contact material consisting of a substrate made of, for example, an Fe/Ni alloy similar to conventional ones and its surface being coated with Mo, W or an alloy thereof.

The above-mentioned contact material is excellent in having a high hardness, a high melting point and a high electric conductivity, among properties required for encapsulated contact materials.

However it has been clarified that this contact material shows the following behaviors.

That is to say, when an encapsulated contact having an encapsulated contact material coated with W is tested by repeating make-and-break, for example, the contact resistance of the encapsulated contact material varies widely. In this case, furthermore, concentrated arching is often observed.

A wide scatter of the contact resistance of an encapsulated contact material not only causes changes in the contact resistance during a make-and-break action of the encapsulated contact but also enhances heat generation at the encapsulated contact. As a result, the operating life of the encapsulated contact is shortened and scattered.

It is considered that these problems are brought about by the fact that Mo, W or alloys thereof constituting the contact-coating layer are each easily oxidized in the atmosphere.

Namely, it is sometimes observed that an electrical insulating oxide layer has been already formed on the surface of such a material prior to the encapsulation. Also, when an encapsulated contact is constructed by encapsulating such a contact material in a glass container, an oxide layer is seemingly formed on the surface of the contact-coating layer simultaneously with the surface-oxidation of a glass-sealing portion of a base metal which is effected before the encapsulation.

It is an object of the present invention to provide an encapsulated contact material, which shows a narrow scatter in the initial contact resistance or contact resistance and is excellent in sticking resistance and arc resistance, and a process for producing the same.

Further, it is another object of the present invention to provide an encapsulated contact material, which has a high melting point, a high hardness and a high electric conductivity, and a process for producing the same.

Furthermore, it is another object of the present invention to provide a less expensive encapsulated contact material, which has a long and stable operating life, and a process for producing the same.

According to a first aspect of the present invention, there is provided an encapsulated contact material comprising a substrate and a contact-coating layer formed on said substrate, characterized by:

said contact-coating layer comprising at least one metal selected from a group consisting of Mo, Zr, Nb, Hf, Ta and W or an alloy made of two or more of these metals, and containing from 0.5 to 10 atomic % of at least one element selected from a group consisting of Li, K, Ce, Cs, Ba, Sr, Ca, Na, Y, La, Sc, Th and Rb, or containing from 0.1 to 5 % by weight of at least one oxide comprising at least one metal selected from a group consisting of Li, K, Ce, Cs, Ba, Sr, Ca, Na, Y, La, Sc, Th and Rb as a main component ; and

having a thickness of 0.1 μm or more.

Thus, in order to achieve the above objects, the present invention provides in a first embodiment an encapsulated contact material comprising a substrate and a contact-coating layer coating the surface of said substrate characterized in that said contact-coating layer has a thickness of 0.1 μm or more and comprises at least one metal selected from a group consisting of Mo, Zr, Nb, Hf, Ta and W or an alloy made of two or more of these metals and containing at least one element selected from a group consisting of Li, K, Ce, Cs, Ba, Sr, Ca, Na, Y, La, Sc, Th and Rb of 0.5 to 10 atomic % (hereinafter referred to as the first material).

The present invention further provides in a second embodiment an encapsulated contact material comprising a substrate and a contact-coating layer coating the surface of said substrate characterized in that said contact-coating layer has a thickness of 0.1 $\mu$m or more and comprises at least one metal selected from a group consisting of Mo, Zr, Nb, Hf, Ta and W or an alloy made of two or more of these metals and containing at least one oxide, as a main component, comprising at least one metal selected from a group consisting of Li, K, Ce, Cs, Ba, Sr, Ca, Na, Y, La, Sc, Th and Rb of 0.1 to 5 % by weight (hereinafter referred to as the second material).

Furthermore, the present invention provides according to a second aspect, a process for producing an encapsulated contact material characterized by comprising the processes of washing the surface of a substrate with ion bombardment or electron shower, heating the substrate to 300 to 900 °C and forming the above-mentioned contact-coating layer on the substrate by physical or chemical deposition method whilst maintaining the above temperature region.

A number of preferred embodiments of the present invention will now be described by way of example only, and with reference to the accompanying drawings, in which:

Fig. 1 is a graph showing relations between the resistance of lead switches having contact materials consisting of the contact-coating layers of Example 2, Comparative Example 1 and Ru being integrated therein and the make-and-break frequency of the lead switches;

Fig. 2 is an electron microscopic photograph of the contact of the contact material (anode) of Example 2 after the completion of the operating life test;

Fig. 3 is an electron microscopic photograph of the contact of the contact material (cathode) of Example 2 after the completion of the operating life test;

Fig. 4 is an electron microscopic photograph of the contact of the contact material (anode) of Comparative Example 1 after the completion of the operating life test; and

Fig. 5 is an electron microscopic photograph of the contact of the contact material (cathode) of Comparative Example 1 after the completion of the operating life test.

In each of the first and second materials of the present invention, the substrate is not particularly restricted but arbitrarily selected from among those which have been used as a substrate for an encapsulated contact material. In order to achieve cost-down, for example, Fe, Ni, Co, Ni-Fe, Co-Fe-Nb, Co-Fe-V, Fe-Ni-Al-Ti, Fe-Co-Ni, carbon steel, phosphor bronze, beryllium copper, nickel silver, brass, stainless steel, Cu-Ni-Sn and Cu-Ti may be used therefor.

In the first material, the surface of the above-mentioned substrate is coated with the contact-coating layer as will be described hereinafter.

This contact-coating layer comprises a material selected from a group consisting of Mo, Zr, Nb, Hf, Ta and W or an alloy such as Hf-Nb, Hf-Ta, Hf-Mo, Hf-Zr, Hf-W, Mo-Nb, Mo-Ta, Mo-W, Mo-Zr, Nb-Ta, Nb-W, Nb-Zr, Ta-W, Ta-Zr or W-Zr as a base and contains from 0.5 to 10 atomic % of one or more selected from among Li, K, Ce, Ls, Ba, Sr, Ca, Na, Y, La, Sc, Th and Rb being added thereto as additive elements.

Each of Mo, Zr, Nb, Hf, Ta, W and alloys thereof has a high hardness and a high melting point and contributes to the enhancement of the abrasion resistance of the contact-coating layer.

Further, each of the above-mentioned additive elements stabilizes the contact resistance of the encapsulated contact material, enhances the resistance to abrasion and oxidization and suppresses the concentrated arcing during a make-and-break action of the encapsulated contact.

The above-mentioned additive elements are liable to generate electrons at a make-and-break action of the contact. Accordingly, it is considered that the arching state during the make-and-break action is uniformized and homogenized thereby. As the result of the uniformization and homogenization of arching state, the contact resistance at the make-and-break action is stabilized.

When oxygen is uptaken from the atmosphere during the formation of the contact-coating layer or the production of the encapsulated contact, the oxygen thus uptaken would permeate into the contact-coating layer while being adsorbed or bonded to the additive elements or the matrix metal. Therefore, the formation of an oxide layer on the surface of the contact-coating layer and the unstabilization of the contact resistance caused thereby, which are observed when the contact-coating layer comprises a metallic carrier (Mo, W, etc.) alone, are thus suppressed.

When the content of the additive elements carrying the above-mentioned roles is less than 0.5 atomic %, the contact resistance becomes unstable and the arcing state is scarcely uniformized nor homogenized. When this content exceeds 10 atomic %, on the other hand, the contact resistance of the contact-coating layer becomes excessively high and the electric conductivity is lowered. Therefore the content of these elements preferably ranges from 2 to 6 atomic %.

The thickness of this contact-coating layer is specified as 0.1 $\mu$m or more. This is because a thickness smaller than 0.1 $\mu$m results in a poor resistance to abrasion of the contact-coating layer, which makes it impossible to achieve any satisfactory operating life.

It seems that the upper limit of the thickness may be appropriately determined by taking the working conditions of the encapsulated contact and material cost into consideration. When the contact-coating layer is formed by the film-forming method as will be described hereinafter, for example, an excessively thick film frequently makes its surface rough and thus results in an increase in the contact resistance. In this case, the film-forming cost is elevated too. Therefore, it is preferable that the upper limit of the thickness is set to 100 μm.

It is preferable that the above-mentioned contact-coating layer further contains at least one elements selected from among Mg, Pb, Sn, Zn, Bi, Ag and Cd in an amount of not more than 2 atomic %, since the operating life of the encapsulated contact thus obtained can be prolonged thereby, compared with a case where no such an element is added.

Although the reason therefor has never been clarified so far, it is assumed as follows. Namely, when the encapsulated contact material undergoes a make-and-break action, the materials constituting its contact-coating layer are gradually evaporated as usual. In the case of the contact-coating layer of the present invention as described above, however, the above-mentioned metals (i.e., Mg, Pb, Sn, Zn, Bi, Ag or Cd) would form an alloy together with the additive elements contained in the contact-coating layer (i.e., Li, K, Ce, Cs, Ba, Sr, Ca, Na, Y, La, Sc, Th or Rb). As the formation of the alloy proceeds as described above, it is considered that these additive elements would not diffuse towards the surface of the contact-coating layer and, therefore, the evaporation of the additive elements is suppressed.

However, it is not preferable that the content of Mg, Pb, Sn, Zn, Bi, Ag, Cd or an alloy thereof carrying these roles exceeds 2 atomic %, since the electrical resistance of the contact-coating layer becomes high and the electrical conductivity is thus deteriorated in this case. The content of these metals preferably ranges from 0.01 to 2 atomic %.

When the contact-coating layer material further contains at least one metal selected from among Al, Si, Zr, Ti, Co, Ta, Fe, Mn and Cr or an alloy such as Al-Co, Al-Cr, Al-Fe, Al-Mn, Co-Cr, Co-Fe, Co-Mn, Co-Si, Co-Ti, Co-Zr, Fe-Mn, Fe-Ti, Fe-Zr, Mn-Si, Mn-Ti, Mn-Zr, Si-Ti, Si-Zr, Ta-Ti, Ta-Zr or Ti-Zr, the oxides of the additive elements formed by oxygen, the invasion of which is unavoidable during the formation of the contact-coating layer or the encapsulation of the contact into a glass container, can be reduced. Thus arcing state can be uniformized and the contact resistance can be stabilized in a make-and-break action of the contact. However, when these metals or alloys are added in an excessively large amount, the contact resistance of the contact-coating layer is elevated and the electrical conductivity is thus deteriorated. It is therefore preferable to add them in an amount of 2 atomic % or less.

Also, it is preferable that the contact-coating layer material further contains 1 to 40 atomic % of oxygen, since arcing state can be uniformized and homogenized in a make-and-break action of the encapsulated contact.

It is considered that this phenomenon is caused by the following fact. Namely, when oxygen is added, a part of Li, K, Ce, Cs, Ba, Sr, Ca, Na, Y, La, Sc, Th or Rb contained in the contact-coating layer material is oxidized. Then the contact is liable to generate electrons in a make-and-break action. As a result, the arcing state becomes uniform and homogeneous.

When the content of oxygen is smaller than 1 atomic %, the above-mentioned effect cannot be sufficiently achieved. When this content exceeds 40 atomic %, on the other hand, the electrical resistance of the contact-coating layer is elevated and the electrical conductivity is deteriorated. The content of oxygen preferably ranges from 5 to 40 atomic %.

In order to add oxygen carrying the above-mentioned role, a film is formed whilst controlling the oxygen partial pressure in the atmosphere during the film-forming process, as will be described hereinafter, to thereby add a definite amount of oxygen to the contact-coating layer thus formed. Alternately, the contact-coating layer is once formed on the surface of the substrate and then heated in an oxygen-containing atmosphere such as air.

In the latter case, the surface of the contact-coating layer is oxidized and oxygen diffuses into the contact-coating layer, thus causing partial oxidation of the additive elements contained therein. In this process, the content of oxygen in the contact-coating layer is adjusted to 1 to 40 atomic % by controlling the oxygen partial pressure, the treating temperature and the treating time.

In the air atmosphere, for example, it is preferable to carry out this treatment at a temperature of 100 to 400 °C for 5 minutes to 36 hours. When the treating temperature is lower than 100 °C, oxidation hardly proceeds. When it exceeds 400 °C, on the other hand, excessive oxidation would occur.

It is further preferable that the contact-coating layer material contains at least one substance selected from among $LaB_6$, TiC, TaC, ZrC, TaN and $TiB_2$, since the arcing state at a make-and-break action of the encapsulated contact can be thus homogenized. However, when such a substance is added in an excessively large amount, the electrical resistance of the contact-coating layer is elevated and the electrical conductivity is de-

EP 0 612 085 A2

teriorated. It is therefore needed to control the content thereof to 1 % by weight or less. The content preferably ranges from 0.01 to 1 % by weight.

Although this contact-coating layer may have a single-layer construction, it preferably has a multi-layer construction wherein a plural number of layers are laminated and the thickness of the whole layers is controlled to 0.1 µm or less.

The reason therefor is as follows. Namely, in the film-forming method as will be described hereinafter, the thinner the layer is formed, the less the number of pinholes generated in the layer becomes. Therefore a less number of pinholes are formed in the contact-coating layer (multi-layered) thus formed and the contact characteristics are improved.

In the formation of the contact-coating layer consisting of a plural number of layers, layers contacted with each other may be made of either the same materials or different ones. In the latter case, the characteristics of the layers make up for shortages with each other.

Such a contact-coating layer is formed by washing the surface of a substrate with, for example, ion bombardment with the use of a rare gas (for example, Ar, Ne or Kr) or electron shower and then forming a film of a determined material as described above on the surface by a conventional physical or chemical deposition method (for example, plasma CVD, spattering, ion assist deposition or ion plating).

During this film-forming treatment, the surface temperature of the substrate is kept to 300 to 900 °C.

When this temperature is lower than 300 °C, the contact-coating layer undergoes insufficient crystallization or has a porous column texture. As a result, problems including corrosion and the diffusion of the material would frequently arise. When the temperature exceeds 900 °C, the contact-coating layer is formed as a coarse column texture and the roughness of the surface of the contact-coating layer becomes large. The rough surface of the contact-coating layer results in an elevated or unstabilized contact resistance. The surface temperature of the substrate preferably ranges from 400 to 800 °C, though it may vary depending on the type of the material forming the contact-coating layer.

Between the above-mentioned contact-coating layer and the substrate, the first material of the present invention preferably involves an intermediate layer comprising a metal selected from among Ag, Al, Au, Co, Fe. Mg, Ni, Pd, Pt, Sr, Cr or an alloy such as Ag-Al, Ag-Au, Ag-Mg, Ag-Ni, Ag-Pd, Ag-Pt, Ag-Cr, Al-Mg, Au-Co, Au-Fe, Au-Co, Au-Ni, Au-Pd, Au-Pt, Co-Cr, Co-Fe, Co-Ni, Co-Pd, Co-Pt, Cr-Pd, Fe-Ni, Mg-Ni, Ni-Pd or Pd-Pt.

The above-mentioned metals or alloys thereof, which are excellent in electrical conductivity and have a soft texture, can enhance the adhesiveness of the contact-coating layer to the substrate and reduce the number of intralayer pinholes formed at the formation of the contact-coating layer, thus smoothening the surface of the contact-coating layer.

The thickness of this intermediate layer is preferably controlled to 0.05 µm or more. When this intermediate layer has a thickness less than 0.05 µm, the effect of reducing the number of intralayer pinholes formed in the contact-coating layer laminated on this intermediate layer is worsened. The upper limit of the thickness of the intermediate layer may be appropriately determined by taking the film-forming cost, and the intervals between encapsulated contact materials and sizes of encapsulated contact materials into consideration. A thickness of 5 µm is sufficient at the largest.

This intermediate layer may have either a single-layer structure or a multi-layer one consisting of a plural number of layers being laminated on each other. The latter case is a preferable one, since the number of intralayer pinholes formed in the contact-coating layer laminated on the intermediate layer can be thus reduced. To form the multi-layer construction, layers being contacted with each other may be made of either the same or different materials. In the latter case, the characteristics of the layers make up for shortages with each other.

Such an intermediate layer is formed by washing the surface of a substrate with, for example, ion bombardment or electron shower and then forming a film of a determined material as described above on the surface of the substrate by a conventional physical or chemical deposition method (for example, plasma CVD, spattering, ion assist deposition or ion plating), similar to the above-mentioned case of the film-formation of the contact-coating layer. Alternately, a film of the intermediate layer may be formed on the surface of the substrate by electroplating.

After forming the intermediate layer on the surface of the substrate and further forming a contact-coating layer thereon, the whole composite may be heated to 300 to 900 °C. Thus the materials of the intermediate layer, substrate and contact-coating layer undergo diffusion with each other, thus elevating the respective adhesiveness between the contact-coating layer, intermediate layer and substrate.

In the case of the first material of the present invention, it is preferable that the surface of the contact-coating layer is coated with a layer of a metal selected from among Ru, Rh, Re, Pd, Os, Ir, Pt, Ag and Au or an alloy such as Ag-Au, Ag-Pd, Ag-Pt, Ag-Rh, Au-Pd, Au-Pt, Au-Rh, Ir-Os, Ir-Pt, Ir-Ru, Os-Pd, Os-Ru, Pd-Pt, Pd-Rh, Pd-Ru, Pt-Rh, Re-Rh or Re-Ru; or a layer of a metal oxide comprising $RuO_2$, $Rh_2O_3$, $RhO_2$, $ReO_2$, $ReO_3$, $OsO_4$, $IrO_2$, or $Ir_2O_3$ either alone or as a main component to thereby form the outmost layer, since a wide scatter of the initial contact resistance of the encapsulated contact material thus obtained can be suppressed thereby.

The thickness of the outmost layer is preferably adjusted to 0.05 $\mu$m or more. When the thickness of this layer is less than 0.05 $\mu$m, the above-mentioned effect cannot be exerted. The upper limit of the thickness of the outmost layer may be appropriately determined by taking the film-forming cost, and the intervals between the encapsulated contact materials and sizes of the encapsulated contact materials into consideration. It is sufficient that the thickness is about 20 $\mu$m at the largest.

Similar to the above-mentioned case, these layers can be formed by conventional film-forming methods such as plasma CVD, spattering, ion assist deposition and ion plating or electro-plating.

Next, the second material of the present invention will be described.

The contact-coating layer of this material consists of a material prepared by adding from 0.1 to 5 % by weight of an oxide mainly comprising at least one element selected from a group consisting of Li, K, Ce, Cs, Ba, Sr, Ca, Na, Y, La, Sc, Th and Rb to a base of a metal or an alloy decribed above concerning to the first material.

Similar to the first material of the present invention, this encapsulated contact material having such a contact-coating layer shows uniformized and homogenized arcing state at a make-and-break action of the contact. Further, its contact resistance is stabilized, its resistance to abrasion is improved and its operating life is prolonged.

When the content of the above-mentioned oxide is less than 0.1 % by weight, the contact resistance becomes unstable. When this content exceeds 5 % by weight, the electrical resistance of the contact-coating layer is elevated and the electrical conductivity is deteriorated. Thus the content preferably ranges from 0.5 to 4 % by weight.

Due to the same reason as the case of the first material, the thickness of the contact-coating layer of this second material is set to 0.1 $\mu$m or more. Similarly, the upper limit thereof is set to 100 $\mu$m.

It is preferable to add a metal selected from a group consisting of Al, Si, Zr, Ti, Co, Ta, Fe, Mn and Cr or an alloy such as Al-Co, Al-Cr, Al-Fe, Al-Mn, Co-Cr, Co-Fe, Co-Mn, Co-Si, Co-Ti, Co-Zr, Fe-Mn, Fe-Ti, Fe-Zr, Mn-Si, Mn-Ti, Mn-Zr, Si-Ti, Si-Zr, Ta-Ti, Ta-Zr or Ti-Zr in an amount of 2 atomic % or less to the contact-coating layer of this second material by the same method as the one employed in the case of the first material of the present invention, since the operating life of the encapsulated contact thus obtained can be prolonged thereby, compared with a case where neither any above metal nor any above alloy is added.

Although the reason for this fact has never been clarified so far, it is assumed as follows. Namely, Al, Si, Zr, Ti, Co, Ta, Fe, Mn, Cr or an alloy thereof partially reduces the oxide of the additive element. Therefor, the additive element is activated, and liable to generate electrons. As a result, arcing state is uniformized and the contact resistance is stabilized at a make-and-break action.

When Al, Si, Zr, Ti, Co, Ta, Fe, Mn, Cr or an alloy thereof carrying the above-mentioned role is contained in an amount exceeding 2 atomic %, however, the electrical resistance of the contact-coating layer is elevated and the electrical conductivity is thus deteriorated. Accordingly, the preferable content of the above component ranges from 0.01 to 2 atomic %.

Similar to the contact-coating layer of the first material of the present invention, the contact-coating layer of the second material may contain 1 % by weight or less of one or more component selected from among $LaB_6$, TiC, TaC, ZrC, TaN and $TiB_2$. Further, it may have a multi-layer construction. In each case, a similar effect as the one of the first material can be obtained.

Furthermore, this second material may have an intermediate layer between the substrate and the contact-coating layer, and, the surface of the contact-coating layer may be coated with a layer of a metal, an alloy or an metal oxide similar to those cited above relating to the first material. In each case, a similar effect as the one of the first material can be obtained.

Examples

Examples 1 to 14 and Comparative Example 1 to 5

A lead pin made of an alloy of 52 % Ni-Fe and being in the form of a plate (1 mm x 1 mm) was prepared as a substrate. The surface of this substrate was ultrasonic-washed by using acetone for 5 minutes. Further, the surface was washed by electrolytical polishing with a phosphate electrolyte.

Next, the substrate was located in a chamber of a vacuum deposition device and the chamber was exhausted to $2 \times 10^{-4}$ Pa or below. Subsequently, the exhaust conductance was reduced by semi-opening a valve of a vacuum pump and Ar gas was introduced therein until the pressure in the chamber reached $1 \times 10^{-1}$ Pa. A voltage of -400 V was applied to the substrate and a high-frequency of 0.2 kW was generated from a high-frequency antenna in the chamber. The substrate was maintained at the temperature as specified in Table 1 by heating and each element as listed in Table 1 was evaporated from an electron beam evaporation source and deposited on the surface of the substrate at a rate of 20 Å/sec. Thus each contact-coating layer having the composition and thickness as specified in Table 1 was formed and a contact material was produced.

The characteristics of each of the contact materials thus obtained were examined in the following manner.

Contact resistance: Immediately after the completion of the production and after allowing to stand in an $N_2$ atmosphere at 430 °C for 30 minutes, a part (1 mm x 1 mm) of a contact material was contacted with a probe of pure Au under a contact load of 0.01 Newton. Then the contact resistance (m$\Omega$) was measured by a four-terminal method. The measurement was performed at room temperature in the air.

Operating life: By using a pair of each contact materials, a lead switch having $N_2$ as an encapsulating gas was formed. Under passing through an electric current of 0.5 A at room temperature and at 100 V, a make-and-break action of 10 Hz was repeated with a driving magnetic field of 40 AT (ampere turn). The number of the make-and-break actions repeated until a fault occurred was recorded.

When any make-and-break action could not be performed due the the fusion of the contact portion or the resistance between the electrodes of the lead switch exceeded 1$\Omega$, it was regarded that a fault occurred.

Table 1 summarizes the results.

Table 1

| | | | Example Nos. | | | | | | | | | | | | | | Comparative Example Nos. | | | | |
|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 | 1 | 2 | 3 | 4 | 5 |
| Substrate temperature at film-forming | | | 700 | 700 | 700 | 700 | 700 | 700 | 700 | 700 | 700 | 700 | 700 | 600 | 600 | 600 | 700 | 600 | 700 | 700 | 700 |
| Contact-coating layer | Base metal | | W | W | W | W | W | W | W | W | W | W | W | Mo | Mo | Mo | W | Mo | W | W | W |
| | Additive element | Sort | Sr | Sr | Sr | Sr | Sr | Sr | Ba | Li | Cs | La | Th | Sr | Cs | Th | – | – | Sr | Sr | Sr |
| | | Content (atomic %) | 0.5 | 3.7 | 6.8 | 9.9 | 3.7 | 3.7 | 3.7 | 3.7 | 3.7 | 3.7 | 3.7 | 3.7 | 3.7 | 3.7 | – | – | 0.3 | 11 | 3.7 |
| | Thickness (μm) | | 2 | 2 | 2 | 2 | 0.1 | 5 | 2 | 2 | 2 | 2 | 2 | 2 | 2 | 2 | 2 | 2 | 2 | 2 | 0.01 |
| Contact resistance (mΩ) | unheated | | 10 | 8 | 10 | 12 | 10 | 8 | 10 | 11 | 8 | 12 | 12 | 13 | 13 | 15 | 25 | 35 | 18 | 20 | 17 |
| | heated | | 13 | 10 | 13 | 15 | 15 | 10 | 13 | 14 | 10 | 15 | 15 | 16 | 16 | 18 | 35 | 50 | 25 | 28 | 30 |
| Operating life (times, 10^6) | | | 4.5 | 6.0 | 5.0 | 4.5 | 2.0 | 10.0 | 5.5 | 5.0 | 6.0 | 5.0 | 5.0 | 4.0 | 3.5 | 3.0 | 0.2 | 0.1 | 0.25 | 0.4 | 0.1 |

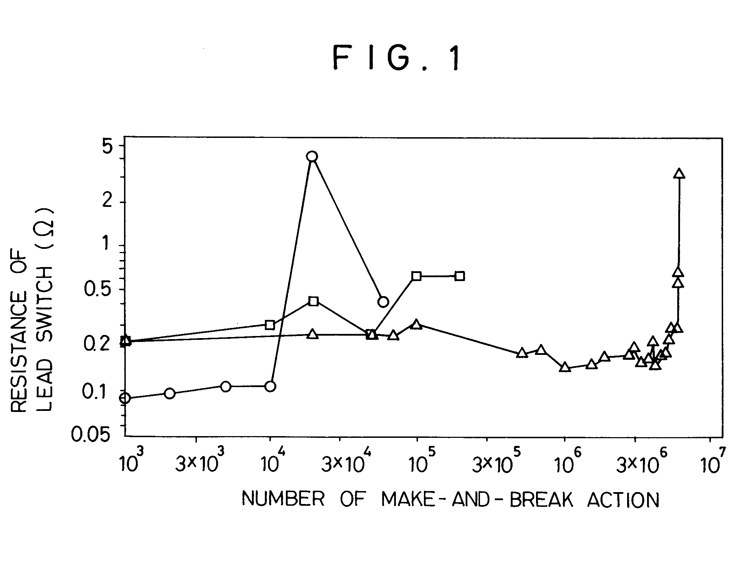

Also, the relationships between the number of make-and-break actions and resistance of a lead switch having the contact material of Example 2 being integrated therein and another lead switch having the contact material of Comparative Example 1 being incorporated therein were examined. Fig. 1 shows the results. For reference, a lead switch having a contact material with a contact-coating layer comprising Ru being integrated therein was also tested. The result is given in Fig. 1.

In Fig. 1, triangles show the data of the lead switch having the contact material of Example 2, circles show the data of the one having the contact material of Comparative Example 1 and squares show the data of the one having the referential contact material, respectively.

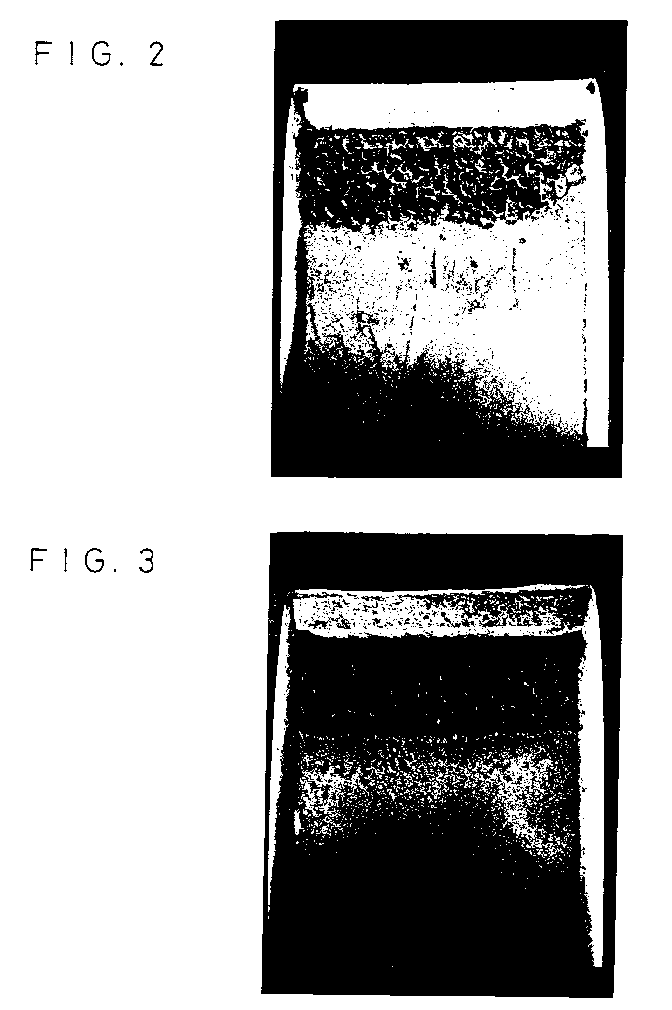

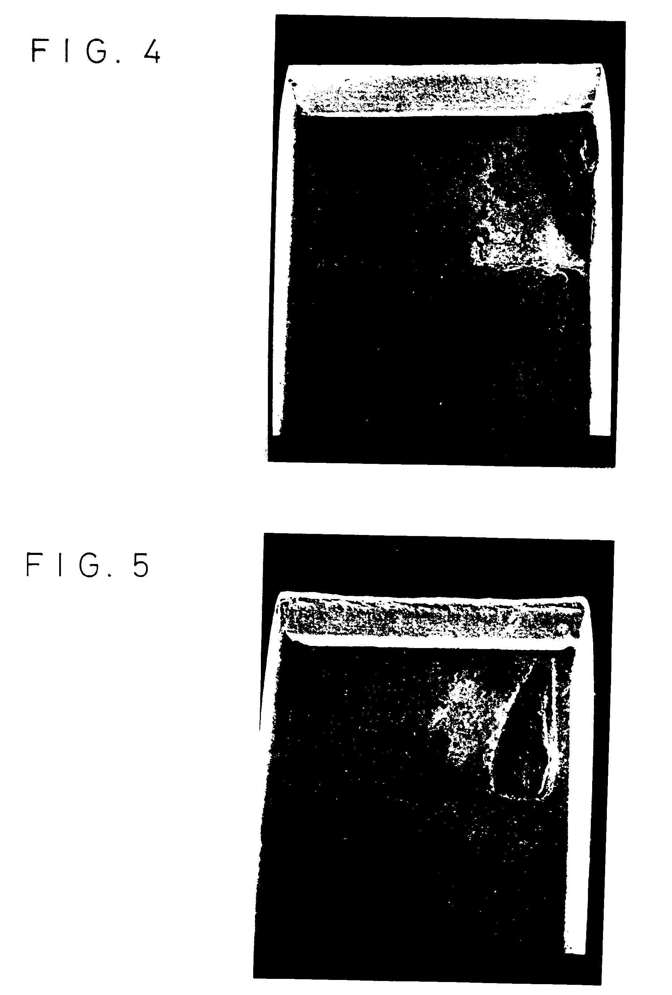

When the operating lives of the contact materials of Example 2 and Comparative Example 1 were terminated (Example 2: $6 \times 10^6$ times, Comparative Example 1: $2 \times 10^5$ times), the surface of the contact portion of each lead switch was observed under an electron microscope. Figs. 2 and 3 are electron microscopic photographs of the anode and cathode, respectively, of the contact material of Example 2 and Figs. 4 and 5 are electron microscopic photographs of the anode and cathode, respectively, of the contact material of Comparative Example 1.

As the results given in Table 1 clearly shows, the operating lives of the contact materials of the present invention are remarkably longer than those of the contact materials of Comparative Examples. Further, the contact resistances of the contact materials of the present invention are lower than those of the contact materials of Comparative Examples both immediately after the production and after heating.

Further, as Fig. 1 clearly shows, the resistance between the electrodes of the lead switch having the contact material of the present invention (Example 2) suffers from less scatter and remains stable, compared with those of the lead switches having the contact material of Comparative Example 1 and the referential contact material.

That is to say, the contact material of the present invention is a material having a low and stable contact resistance.

A comparison of Fig. 2 (Fig. 3) with Fig. 4 (Fig. 5) indicates that the contact material of Example 2 is deteriorated almost uniformly over a wide area, while the contact material of Comparative Example 1 shows concentrate deterioration. These facts suggest that arcing occurred and proceeded uniformly and homogeneously in the contact material of Example 2, while concentrate arcing resulted in fusion in the affected part in the contact material of Comparative Example 1.

Examples 15 to 23, Comparative Examples 6 to 8

Similar to the procedures of Examples 1 to 14, each element as listed in Table 2 was evaporated from an electron beam evaporation source and deposited on the surface of a substrate, which was maintained at 700 °C, at a deposition rate of 20 Å/sec. Thus each contact-coating layer having the composition and thickness as specified in Table 2 was formed and a contact material was produced.

The contact resistance and operating life of each contact material thus obtained were examined in the same manners as those employed in Examples 1 to 14.

Table 2 shows the results.

Table 2

| Contact-coating layer | | | Example Nos. | | | | | | | | | | | | | | | | Comparative Example Nos. | | | | | |
|---|---|---|---|---|---|---|---|---|---|---|---|---|---|---|---|---|---|---|---|---|---|---|---|---|---|
| | | | 15 | | 16 | | 17 | | 18 | | 19 | | 20 | | 21 | | 22 | | 23 | | 6 | | 7 | | 8 | |
| | Base metal | | W | | W | | W | | W | | W | | W | | W | | W | | W | | W | | W | | W | |
| | Additive element | Sort | Sr | Mg | Sr | Mg | Sr | Mg | Sr | Sn | Sr | Sn | Sr | Sn | Sr | Ag | Sr | Ag | Sr | Ag | Sr | Mg | Sr | Sn | Sr | Ag |
| | | Content (atomic %) | 3.7 | 0.02 | 3.7 | 0.2 | 3.7 | 2.0 | 3.7 | 0.02 | 3.7 | 0.2 | 3.7 | 2.0 | 3.7 | 0.02 | 3.7 | 0.2 | 3.7 | 2.0 | 3.7 | 3.0 | 3.7 | 3.0 | 3.7 | 3.0 |
| | Thickness (μm) | | 2 | | 2 | | 2 | | 2 | | 2 | | 2 | | 2 | | 2 | | 2 | | 2 | | 2 | | 2 | |
| Contact resistance (mΩ) | unheated | | 12 | | 14 | | 16 | | 12 | | 13 | | 15 | | 12 | | 13 | | 16 | | 20 | | 21 | | 23 | |
| | heated | | 15 | | 16 | | 18 | | 15 | | 16 | | 18 | | 15 | | 16 | | 18 | | 24 | | 25 | | 28 | |
| Operating life (times, $10^6$) | | | 6.5 | | 7.0 | | 7.0 | | 6.5 | | 7.0 | | 7.0 | | 6.5 | | 7.0 | | 7.0 | | 4.0 | | 4.5 | | 4.0 | |

10

As the results given in Table 2 clearly show, when Mg, Sn or Ag was added to the composition of the contact-coating layer of Example 2, the contact resistance was somewhat elevated but the operating number was further increased. When the content of Mg, Sn or Ag exceeded 2 atomic %, however, the contact resistance was elevated and the operating number was lowered.

Examples 24 to 27, Comparative Examples 9 and 10

The same procedure of Examples 1 to 14 was used but W and Sr were evaporated from an electron bean evaporation source by controlling the oxygen partial pressure in the chamber and deposited on the surface of a substrate at a deposition rate of 20 Å/sec. Thus each contact-coating layer having the composition and thickness as specified in Table 3 was formed and a contact material was produced.

The contact resistance and operating life of each contact material thus obtained were examined in the same manners as those employed in Examples 1 to 14.

Table 3 shows the results.

Table 3

| | | | Example Nos. | | | | Comparative Example Nos. | |
|---|---|---|---|---|---|---|---|---|
| | | | 24 | 25 | 26 | 27 | 9 | 10 |
| Contact-coating layer | Base metal | | W | W | W | W | W | W |
| | Additive element | Sort | Sr / O | Sr / O | Sr / O | Sr / O | Sr / O | Sr / O |
| | | Content (atomic %) | 3.7 / 1.0 | 3.7 / 1 0 | 3.7 / 2 5 | 3.7 / 4 0 | 3.7 / 0.5 | 3.7 / 4 3 |
| | Thickness ($\mu$m) | | 2 | 2 | 2 | 2 | 2 | 2 |
| Contact resistance (m$\Omega$) | unheated | | 1 2 | 1 3 | 1 4 | 1 6 | 1 2 | 2 5 |
| | heated | | 1 5 | 1 6 | 1 6 | 1 8 | 1 5 | 3 0 |
| Operating life (times, $10^6$) | | | 6.5 | 7.0 | 7.0 | 7.0 | 6.0 | 5.0 |

As the results given in Table 3 clearly show, when the contact-coating layer of Example 2 contained oxygen, the contact resistance was somewhat elevated but the operating number was increased. When the content of oxygen exceeded 40 atomic %, however, the contact resistance became extremely high and the operating number began to decrease.

Examples 28 to 36.

The contact material employed in Example 2 was maintained at a temperature of 250 °C and each element as listed in Table 4 was evaporated from an electron beam evaporation source to thereby form an intermediate layer film of the thickness as specified in Table 4. Next, the substrate was heated to 700 °C and W and Sr were evaporated from an electron beam evaporation source at the same temperature and deposited on the surface of the above-mentioned intermediate layer at a deposition rate of 20 Å/sec. Thus each contact-coating layer having the composition and thickness as specified in Table 4 was formed and a contact material was produced.

The contact resistance and operating life of each contact material thus obtained were examined in the same manner as the one described in Example 2. Table 4 summarizes the results.

Table 4

| | | Example Nos. | | | | | | | | |
|---|---|---|---|---|---|---|---|---|---|---|
| | | 28 | 29 | 30 | 31 | 32 | 33 | 34 | 35 | 36 |
| Intermediate layer | Sort | Ag | Ag | Ag | Ni | Al | Au | Sr | Cr | Ag |
| | Thickness ($\mu$m) | 0.05 | 1.0 | 5.0 | 0.1 | 0.1 | 0.1 | 0.1 | 0.1 | 0.01 |
| Contact-coating layer | Base metal | W | W | W | W | W | W | W | W | W |
| | Additive element — Sort | Sr | Sr | Sr | Sr | Sr | Sr | Sr | Sr | Sr |
| | Additive element — Content (atomic %) | 3.7 | 3.7 | 3.7 | 3.7 | 3.7 | 3.7 | 3.7 | 3.7 | 3.7 |
| | Thickness ($\mu$m) | 2 | 2 | 2 | 2 | 2 | 2 | 2 | 2 | 2 |
| Contact resistance (m$\Omega$) | unheated | 7 | 6 | 6 | 7 | 7 | 6 | 7 | 7 | 8 |
| | heated | 9 | 8 | 8 | 9 | 9 | 8 | 9 | 9 | 10 |
| Operating life (times, $10^6$) | | 6.5 | 7.0 | 7.0 | 6.5 | 6.5 | 7.0 | 6.5 | 6.5 | 6.0 |

As the results given in Table 4 show, when the contact material of Example 2 involved an intermediate layer comprising Ag, Ni, Al, Au, Sr or Cr between the substrate and the contact-coating layer, the contact resistance was somewhat lowered and the operating number was somewhat increased. When the thickness of the intermediate layer was less than 0.05 $\mu$m, however, these effects could not be obviously observed.

Examples 37 to 44, Comparative Example 11

By using the same procedure as those of Examples 2 and 12, each contact-coating layer having the composition and thickness as specified in Table 5 was formed on the surface of a substrate. Then the substrate temperature was lowered to 300 °C and the element as specified in Table 5 was evaporated at the same temperature from an electron bean evaporation source. Thus a metal layer of a determined thickness was formed as the outmost layer on the surface of the above-mentioned contact-coating layer.

The contact resistance and operating life of each contact material thus obtained were examined in the same manner as those of Examples 2 and 12. Table 5 shows the results.

## Table 5

| | | 37 | 38 | 39 | 40 | 41 | 42 | 43 | 44 | Comparative Example 11 |
|---|---|---|---|---|---|---|---|---|---|---|
| Contact-coating layer | Base metal | Sort | W | W | W | W | W | W | Mo | Mo | W |
| | Additive element | Sort | Sr | Sr | Sr | Sr | Sr | Sr | Sr | Sr | Sr |
| | | Content (atomic %) | 3.7 | 3.7 | 3.7 | 3.7 | 3.7 | 3.7 | 3.7 | 3.7 | 3.7 |
| | Thickness ($\mu$m) | | 2 | 2 | 2 | 2 | 2 | 2 | 2 | 2 | 2 |
| Metal layer (outmost layer) | Sort | | Ru | Ru | Ru | Rh | Ir | Os | Ru | Ir | Ru |
| | Thickness ($\mu$m) | | 0.05 | 0.1 | 1.0 | 0.1 | 0.1 | 0.1 | 0.1 | 0.1 | 0.01 |
| Contact resistance (m$\Omega$) | unheated | | 10 | 10 | 10 | 10 | 10 | 10 | 14 | 14 | 9 |
| | heated | | 11 | 10 | 10 | 11 | 11 | 11 | 15 | 15 | 12 |
| Operating life (times, [6]) | | | 6.5 | 7.0 | 7.0 | 7.0 | 7.0 | 7.0 | 4.5 | 5.0 | 6.0 |

As the results given in Table 5 clearly show, when the surface of the contact-coating layer of the contact material of Example 2 or Example 12 was coated with a metal such as Ru, Rh, Ir or Os, the operating number was somewhat increased. When the thickness of this metal layer was less than 0.05 μm, however, the above-mentioned effect could not be obviously observed.

Examples 45 and 46

The substrate employed in Examples 1 was set in a vacuum chamber. Under an Ar gas atmosphere of 5 mTorr in the chamber, the surface temperature of the substrate was elevated to 400 °C. While maintaining at the same temperature, a contact-coating layer having each composition and thickness as specified in Table 6 was formed on the surface of the substrate by DC magnetron spattering of 0.5 W with the use of W and Sr as a target. Next, the target was replaced and and the oxygen partial pressure was controlled and a metal oxide layer having the composition and thickness as specified in Table 6 was formed as the outmost layer on the surface of the above-mentioned contact-coating layer by DC magnetron spattering at 0.5 kW. Thus a contact material was produced.

The contact resistance, operating life of each of the contact materials thus obtained were examined in the same manner as those described in Examples 37 to 44. Table 6 shows the results.

Table 6

| Contact-coating layer | | | Example 45 | Example 46 |
|---|---|---|---|---|
| | Base metal | | W | W |
| | Additive element | Sort | Sr | Sr |
| | | Content (atomic %) | 3.7 | 3.7 |
| | Thickness ($\mu$ m) | | 2 | 2 |
| Metal layer (outmost layer) | | Sort | $Rh_2O_3$ | $Ir_2O_3$ |
| | | Thickness ($\mu$ m) | 0.1 | 0.1 |
| Contact resistance (m $\Omega$) | | unheated | 9 | 9 |
| | | heated | 10 | 10 |
| Operating life (times, $10^6$) | | | 7.0 | 7.0 |

Examples 47 and 48

The substrate employed in Example 1 was maintained at a temperature of 250 °C and each element as specified in Table 7 was evaporated from an electron beam evaporation source. Thus an intermediate layer having the thickness as defined in Table 7 was formed. Next, the temperature of the substrate was elevated to 700 °C (in the case of Example 47) or 600 °C (in the case of Example 48). While maintaining at this temperature, W and Sr were evaporated from an electron bean evaporation source to thereby form a contact-coating layer having the composition and thickness as specified in Table 7. Subsequently, the temperature of the substrate was lowered to 300 °C and the element as specified in Table 7 was evaporated at the same temperature from an electron beam evaporation source. Thus a metal layer of the determined thickness was formed as the outmost layer on the surface of the above-mentioned contact-coating layer and a contact material was produced.

The contact resistance and operating life of each of the contact materials thus obtained were examined by the same manner as those described in Examples 1 to 14, 28 to 35 and 37 to 44.

Table 7 summarizes the results.

Table 7

| | | | Example 47 | Example 48 |
|---|---|---|---|---|
| Contact-coating layer | Intermediate layer | Sort | Ag | Au |
| | | Thickness (μm) | 0.1 | 0.1 |
| | Base metal | | W | Mo |
| | Additive element | Sort | Sr | Sr |
| | | Content (atomic %) | 3.7 | 3.7 |
| | Thickness (μm) | | 2 | 2 |
| Metal oxide layer (outmost layer) | Sort | | Ru | Rh |
| | Thickness (μm) | | 0.1 | 0.1 |
| contact resistance (mΩ) | unheated | | 8 | 13 |
| | heated | | 9 | 14 |
| Operating life (times, 6) | | | 7.5 | 7.5 |

Examples 49 to 51, Comparative Example 12 and 13

The contact material of Example 2 was heated at each temperature as specified in Table 8 for a determined period of time to induce surface oxidation.

The contact resistance and operating life of each of these oxidized products were examined by the same method as those described in Examples 1 to 14. Table 8 shows the results.

Table 8

| | | Example Nos. | | | Comparative Example Nos. | | Example 2 |
|---|---|---|---|---|---|---|---|
| | | 49 | 50 | 51 | 12 | 13 | |
| Oxida-tion | Temperature(°C) | 100 | 250 | 400 | 70 | 500 | - |
| | Time (hr) | 24 | 24 | 24 | 24 | 24 | - |
| Contact resistance (mΩ) | unheated | 10 | 12 | 14 | 9 | 30 | 8 |
| | heated | 12 | 14 | 16 | 11 | 35 | 10 |
| Operating life(times, $10^6$) | | 6.5 | 7.0 | 6.5 | 6.0 | 1.0 | 6.0 |

18

Examples 52 to 68, Comparative Examples 14 to 16

The substrate employed in Examples 1 to 14 was set in a vacuum chamber. Under a mixed gas (Ar + $O_2$) atmosphere of 10 mTorr in the chamber, the surface temperature of the substrate was elevated to 400 °C. With maintaining the same temperature, W, Mo and each oxide as listed in Table 9 were used as a target and each contact-coating layer having the composition and thickness as specified in Table 9 was formed on the surface of the substrate by d.c. magnetron spattering at 0.7 kW. Thus a contact material was produced.

The contact resistance and operating life of each of the contact materials thus obtained were examined by the same method as those described in Examples 1 to 14. Table 9 shows the results.

Table 9

| | | | Example Nos. | | | | | | | | | | | | | | | | Comparative Example Nos. | | |
|---|---|---|---|---|---|---|---|---|---|---|---|---|---|---|---|---|---|---|---|---|---|---|
| | | | 52 | 53 | 54 | 55 | 56 | 57 | 58 | 59 | 60 | 61 | 62 | 63 | 64 | 65 | 66 | 67 | 68 | 14 | 15 | 16 |
| Contact-coating layer | Base metal | | W | W | W | W | W | W | W | W | W | W | W | Mo | Mo | Mo | Mo | Mo | Mo | W | W | W |
| | Oxide | Sort | SrO | SrO | SrO | SrO | SrO | SrO | BaO | Li$_2$O | CeO$_2$ | La$_2$O$_3$ | ThO$_2$ | SrO | BaO | Li$_2$O | CeO | La$_2$O$_3$ | ThO$_2$ | SrO | SrO | SrO |
| | | Content (wt %) | 0.2 | 1.8 | 3.4 | 5.0 | 1.8 | 1.8 | 1.8 | 1.8 | 1.8 | 1.8 | 1.8 | 1.8 | 1.8 | 1.8 | 1.8 | 1.8 | 1.8 | 0.1 | 6 | 3.7 |
| | Thickness ($\mu$m) | | 2 | 2 | 2 | 2 | 0.1 | 5 | 2 | 2 | 2 | 2 | 2 | 2 | 2 | 2 | 2 | 2 | 2 | 2 | 2 | 0.01 |
| Contact resistance (m$\Omega$) | unheated | | 11 | 9 | 11 | 13 | 11 | 9 | 10 | 11 | 10 | 12 | 12 | 15 | 16 | 17 | 15 | 17 | 17 | 20 | 25 | 20 |
| | heated | | 13 | 11 | 13 | 15 | 16 | 11 | 12 | 13 | 12 | 14 | 14 | 18 | 18 | 19 | 18 | 19 | 19 | 28 | 35 | 35 |
| Operating life (times, 10$^6$) | | | 4.5 | 6.0 | 5.0 | 4.5 | 2.0 | 10.0 | 5.5 | 5.5 | 6.0 | 5.0 | 5.0 | 4.0 | 3.5 | 3.5 | 4.0 | 3.5 | 3.5 | 0.25 | 0.4 | 0.1 |

20

Examples 69 to 77, Comparative Examples 17 to 19

By using various W, SrO and various ceramics as listed in Table 10 as a target, contact-coating layers having the composition and thickness as specified in Table 10 were formed in the same manner as those of Examples 52 to 68.

The contact resistance and operating life of each of the contact material thus obtained were examined. Table 10 shows the results.

Table 10

EP 0 612 085 A2

| | | | Example Nos. | | | | | | | | | | | | | | | | | | | Comparative Example Nos. | | | | | |
|---|---|---|---|---|---|---|---|---|---|---|---|---|---|---|---|---|---|---|---|---|---|---|---|---|---|---|---|---|
| | | | 69 | | 70 | | 71 | | 72 | | 73 | | 74 | | 75 | | 76 | | 77 | | 17 | | 18 | | 19 | |
| Contact-coating layer | Base metal | | W | | W | | W | | W | | W | | W | | W | | W | | W | | W | | W | | W | |
| | Substance | Sort | SrO | LaB$_6$ | SrO | LaB$_6$ | SrO | LaB$_6$ | SrO | ZrC | SrO | ZrC | SrO | ZrC | SrO | TaN | SrO | TaN | SrO | TaN | SrO | LaB$_6$ | SrO | ZrC | SrO | TaN |
| | | Content (wt%) | 1.8 | 0.01 | 1.8 | 0.1 | 1.8 | 1.0 | 1.8 | 0.01 | 1.8 | 0.1 | 1.8 | 1.0 | 1.8 | 0.01 | 1.8 | 0.1 | 1.8 | 1.0 | 3.7 | 2.0 | 3.7 | 2.0 | 3.7 | 2.0 |
| | Thickness (μm) | | 2 | | 2 | | 2 | | 2 | | 2 | | 2 | | 2 | | 2 | | 2 | | 2 | | 2 | | 2 | |
| Contact resistance (mΩ) | unheated | | 9 | | 10 | | 11 | | 9 | | 10 | | 12 | | 9 | | 10 | | 13 | | 14 | | 15 | | 15 | |
| | heated | | 11 | | 12 | | 13 | | 11 | | 12 | | 14 | | 11 | | 13 | | 15 | | 17 | | 18 | | 18 | |
| Operating life (times, 10$^6$) | | | 6.5 | | 7.0 | | 6.5 | | 6.5 | | 7.0 | | 6.5 | | 6.5 | | 7.0 | | 6.5 | | 5.0 | | 5.0 | | 5.0 | |

22

Examples 78 to 80

By using the same procedure as that of Examples 52 to 68, each contact-coating layer having the composition and thickness as specified in Table 11 was formed on a substrate. After replacing the target, a metal layer having the thickness as specified in Table 11 was formed as the outmost layer on the above-mentioned contact-coating layer by d.c. magnetron spattering at 0.5 kW. Thus contact materials were produced.

The contact resistance and operating life of each of the contact materials thus obtained were examined. Table 11 shows the results.

Table 11

| | | | Example 78 | Example 79 | Example 80 |
|---|---|---|---|---|---|
| Contact-coating layer | Base metal | | W | W | W |
| | Oxide | Sort | S r O | T h O$_2$ | C e O$_2$ |
| | | Content (wt%) | 3. 7 | 3. 7 | 3. 7 |
| | Thickness ($\mu$m) | | 2 | 2 | 2 |
| Metal layer (outmost layer) | Sort | | R h | O s | R u |
| | Thickness ($\mu$m) | | 0. 1 | 0. 1 | 0. 1 |
| Contact resistance (m$\Omega$) | unheated | | 1 0 | 1 3 | 1 1 |
| | heated | | 1 1 | 1 4 | 1 2 |
| Operating life (times, 10$^6$) | | | 7. 0 | 7. 0 | 7. 0 |

Examples 81 to 89, Comparative Examples 20 to 22

By using W, SrO and various metals as listed in Table 12 as a target, each contact-coating layer having the composition and thickness as specified in Table 12 was formed on the surface of a substrate.

The contact resistance and operating life of each of the contact materials thus obtained were examined. Table 12 shows the results.

Table 12

EP 0 612 085 A2

| | | | Example Nos. | | | | | | | | | Comparative Example Nos. | | |
|---|---|---|---|---|---|---|---|---|---|---|---|---|---|---|
| | | | 8 1 | 8 2 | 8 3 | 8 4 | 8 5 | 8 6 | 8 7 | 8 8 | 8 9 | 2 0 | 2 1 | 2 2 |
| Base metal | | | W | W | W | W | W | W | W | W | W | W | W | W |
| Oxide | Sort | | SrO | SrO | SrO | SrO | SrO | SrO | SrO | SrO | SrO | SrO | SrO | SrO |
| | Content (wt %) | | 1.8 | 1.8 | 1.8 | 1.8 | 1.8 | 1.8 | 1.8 | 1.8 | 1.8 | 1.8 | 1.8 | 1.8 |
| Metal | Sort | | A l | A l | A l | S i | S i | S i | C r | C r | C r | A l | S i | C r |
| | Content (atomic %) | | 0.02 | 0.2 | 2.0 | 0.02 | 0.2 | 2.0 | 0.02 | 0.2 | 2.0 | 3.0 | 3.0 | 3.0 |
| Thickness ($\mu$m) | | | 2 | 2 | 2 | 2 | 2 | 2 | 2 | 2 | 2 | 2 | 2 | 2 |
| Contact resistance (m$\Omega$) | unheated | | 1 1 | 1 2 | 1 4 | 1 1 | 1 3 | 1 4 | 1 1 | 1 2 | 1 4 | 2 1 | 2 2 | 2 1 |
| | heated | | 1 3 | 1 4 | 1 6 | 1 3 | 1 5 | 1 6 | 1 3 | 1 4 | 1 6 | 2 4 | 2 5 | 2 5 |
| Operating life (times, $10^6$) | | | 6.5 | 7.0 | 7.0 | 6.5 | 7.0 | 7.0 | 6.5 | 7.0 | 7.0 | 4.5 | 4.0 | 4.5 |

24

## Claims

1. An encapsulated contact material comprising a substrate and a contact-coating layer formed on said substrate,
   characterized by:
   said contact-coating layer comprising at least one metal selected from a group consisting of Mo, Zr, Nb, Hf, Ta and W or an alloy made of two or more of these metals,and containing from 0.5 to 10 atomic % of at least one element selected from a group consisting of Li, K, Ce, Cs, Ba, Sr, Ca, Na, Y, La, Sc, Th and Rb, or containing from 0.1 to 5 % by weight of at least one oxide comprising at least one metal selected from a group consisting of Li, K, Ce, Cs, Ba, Sr, Ca, Na, Y, La, Sc, Th and Rb as a main component; and having a thickness of 0.1 μm or more.

2. An encapsulated contact material according to Claim 1, wherein at least one metal selected from a group consisting of Mg, Pb, Sn, Zn, Bi, Ag and Cd is contained in an amount of not more than 2 atomic % in said contact-coating layer.

3. An encapsulated contact material according to Claim 1 or 2, wherein at least one metal selected from a group consisting of Al, Si, Zr, Ti, Co, Ta, Fe, Mn and Cr is contained in an amount of not more than 2 atomic % in said contact-coating layer.

4. An encapsulated contact material according to Claim 1, 2 or 3, wherein said contact-coating layer contains from 1 to 40 atomic % of oxygen.

5. An encapsulated contact material according to Claim 1, 2, 3, or 4, wherein said contact-coating layer contains not more than 1 % by weight of at least one substance selected from a group consisting of $LaB_6$, TiC, TaC, ZrC, TaN and $TiB_2$.

6. An encapsulated contact material according to any preceding claim, wherein said contact-coating layer comprises a plural number of layers.

7. An encapsulated contact material according to Claim 6, wherein said plural number of layers being contacted with each other are made of different materials.

8. An encapsulated contact material according to any preceding claim, wherein an intermediate layer comprising at least one metal selected from a group consisting of Ag, Al, Au, Co, Fe, Mg, Ni, Pd, Pt, Sr and Cr as a main component is located between said substrate and said contact-coating layer.

9. An encapsulated contact material according to Claim 8, wherein said intermediate layer has a thickness of 0.05 μm or more.

10. An encapsulated contact material according to Claim 8 or 9, wherein said intermediate layer comprises a plural number of layers.

11. An encapsulated contact material according to Claim 10, wherein said plural number of layers being contacted with each other are made of different materials.

12. An encapsulated contact material according to any preceding claim, wherein the surface of said contact-coating layer is coated with a metal layer comprising at least one metal selected from a group consisting of Ru, Rh, Re, Pd, Os, Ir, Pt, Ag and Au as a main component, and having a thickness of 0.05 μm or more.

13. An encapsulated contact material according to any of Claims 1 to 11, wherein the surface of said contact-coating layer is coated with a metal oxide layer comprising at least one substance selected from a group consisting of $RuO_2$, $Rh_2O_3$, $RhO_2$, $ReO_2$, $OsO_4$, $IrO_2$ and $Ir_2O_3$ as a main component, and having a thickness of 0.05 μm or more.

14. A process for producing an encapsulated contact material which comprises the following steps:
    the surface of a substrate being washed with ion bombardment or electron shower;
    the surface temperature of said substrate being maintained at 300 to 900 °C; and

a contact-coating layer, which comprises at least one metal selected from a group consisting of Mo, Zr, Nb, Hf, Ta and W or an alloy made of two or more of these metals, and containing from 0.5 to 10 atomic % of at least one element selected from a group consisting of Li, K, Ce, Cs, Ba, Sr, Ca, Na, Y, La, Sc, Th and Rb, or containing from 0.1 to 5 % by weight of at least one oxide comprising at least one metal selected from a group consisting of Li, K, Ce, Cs, Ba, Sr, Ca, Na, Y, La, Sc, Th and Rb as a main component and having a thickness of 0.1 μm or more, being formed on the surface of said substrate by physical or chemical deposition methods.

15. A process for producing an encapsulated contact material according to Claim 14, wherein an intermediate layer comprising at least one metal selected from a group consisting of Ag, Al, Au, Co, Fe, Mg, Ni, Pd, Pt, Sr and Cr as a main component is formed by coating the surface of said substrate by physical or chemical deposition method and then the surface of said intermediate layer is further coated to thereby form said contact-coating layer.

16. A process for producing an encapsulated contact material according to Claim 14 or 15, wherein after the formation of said contact-coating layer, a heat treatment is carried out.

17. A process for producing an encapsulated contact material according to Claims 14,15 or 16, wherein said physical deposition method is a method selected from among spattering, ion assist deposition and ion plating, and said chemical deposition method is a plasma CVD method.

F I G . 1

F I G. 2

F I G. 3

F I G. 4

F I G. 5